# EUROPÄISCHE PATENTSCHRIFT

(11) **EP 3 803 959 B1**
(45) Veröffentlichungstag und Bekanntmachung des Hinweises auf die Patenterteilung: **20.12.2023**
(21) Anmeldenummer: 19730673.1
(22) Anmeldetag: 03.06.2019
(51) Int. Cl.: H01L 21/67, H01L 21/677, B65G 47/51, C25F 3/12

(54) **VERFAHREN ZUR BEHANDLUNG VON OBJEKTEN SOWIE VORRICHTUNG ZUR DURCHFÜHRUNG DES VERFAHRENS**
METHOD FOR TREATING OBJECTS AND APPARATUS FOR CARRYING OUT THE METHOD
PROCÉDÉ DE TRAITEMENT D'OBJETS AINSI QUE DISPOSITIF PERMETTANT LA MISE EN OEUVRE DU PROCÉDÉ

(30) Priorität: 04.06.2018 DE 102018113264
(43) Veröffentlichungstag der Anmeldung: 14.04.2021
(73) Patentinhaber: RENA Technologies GmbH, 78148 Gütenbach (DE)
(72) Erfinder: STRAUB, Benedikt, 78148 Gütenbach (DE); UIHLEIN, Markus, 78148 Gütenbach (DE); KALTENBACH, Florian, 78148 Gütenbach (DE); PEDIADITAKIS, Stephan Alexis, 78148 Gütenbach (DE)
(74) Vertreter: Heyerhoff Geiger GmbH & Co. KG
(86) Internationale Anmeldenummer: PCT/DE2019/100488
(87) Internationale Veröffentlichungsnummer: WO 2019/233526

(56) Entgegenhaltungen:
- DE-A1- 19 717 511
- DE-A1-102007 054 090
- DE-A1-102011 118 441
- DE-A1-102015 121 636
- DE-A1-102016 210 883
- JP-A- H06 208 984
- JP-A- 2017 069 529
- US-A- 3 953 276

## Beschreibung

Die Erfindung betrifft ein Verfahren zur Behandlung von Objekten sowie eine Behandlungsvorrichtung zur Durchführung eines solchen Verfahrens.

Eine Behandlung der Oberflächen von Objekten mittels einer Behandlungslösung kommt in unterschiedlichen technischen Gebieten zum Einsatz. So werden beispielsweise in der Solarzellenindustrie unter anderem nasschemische Ätzverfahren für die Behandlung von Waferoberflächen genutzt.

Die Behandlung der Oberflächen von Objekten kann zum Beispiel in Form einer Tauchbehandlung realisiert werden, wobei eine bestimmte Anzahl von Objekten in ein mit der Behandlungslösung gefülltes Becken eingetaucht wird und dort für eine vorgegeben Zeitdauer verweilt. Hierbei handelt es sich um ein sogenanntes Batch-Verfahren.

Eine weitere Möglichkeit ist die Behandlung der Objekte mittels eines sogenannten Inline-Verfahrens. Dabei werden die Objekte auf einer Transportvorrichtung durch ein Becken transportiert, wobei die Behandlung der Objekte mittels der Behandlungslösung während des Transports der Objekte durch das Becken stattfindet. Im Gegensatz zu Batch-Verfahren, bei denen Objekte systembedingt normalerweise beidseitig behandelt werden, sind bei Inline-Verfahren auf verschiedene Weise einseitige Behandlungen von Objekten realisierbar.

Sowohl bei Batch- als auch bei Inline-Verfahren kann die Qualität des Behandlungsergebnisses unter anderem von der Temperatur und/oder der chemischen Zusammensetzung der Behandlungslösung im Bereich der zu behandelnden Objekte abhängen. Kommt es an den Objekten zum Beispiel zu einem Wärmestau und/oder zu einer Übersättigung mit Reaktionsprodukten, kann dies negative Auswirkungen auf die Qualität des Behandlungsergebnisses haben. Bei einem Ätzverfahren kann es in solch einem Fall beispielsweise zu einer Verringerung der Ätzrate kommen.

Aus den Dokumenten DE 10 2007 054 090 A1 und DE 197 17 511 A1 sind Verfahren zur Behandlung von Objekten bekannt, bei welchen Behandlungslösungsstrahlen nach oben abgestrahlt werden.

Die Dokumente JP2017-69529-A und DE 10 2016 210 883-A1 zeigen weitere Beispiele aus dem Stand der Technik auf.

Eine Aufgabe der vorliegenden Erfindung ist es, bei einer Behandlung von Objekten, insbesondere bei einer einseitigen Behandlung von Objekten, eine bessere Qualität des Behandlungsergebnisses zu ermöglichen.

Diese Aufgabe wird erfindungsgemäß gelöst durch ein Verfahren nach Anspruch 1 sowie durch eine Behandlungsvorrichtung nach Anspruch 5.

Bei dem erfindungsgemäßen Verfahren zur Behandlung von Objekten ist vorgesehen, dass
- zu behandelnde Objekte mittels einer Transportvorrichtung durch ein Becken transportiert werden;
- mittels wenigstens einer mit nach oben gerichteten Austrittsöffnungen versehenen Zuführeinrichtung Behandlungslösung in das Becken eingeleitet wird und die Behandlungslösung dabei mittels der nach oben gerichteten Austrittsöffnungen unter Ausbildung von Behandlungslösungsstrahlen nach oben abgestrahlt wird;
- wobei die Objekte oberhalb der nach oben gerichteten Austrittsöffnungen durch das Becken transportiert werden und
- während des Transports der Objekte durch das Becken eine nach unten weisende Oberfläche der Objekte mit den Behandlungslösungsstrahlen in Kontakt gebracht wird.

Die erfindungsgemäße Behandlungsvorrichtung umfasst
- ein Becken, in welchem eine Behandlungslösung anordenbar ist;
- eine Transportvorrichtung, mittels welcher zu behandelnde Objekte in einer Transportrichtung durch das Becken transportierbar sind;
- wenigstens eine in dem Becken angeordnete Zuführeinrichtung, mittels welcher Behandlungslösung in das Becken einleitbar ist;
- wobei die wenigstens eine Zuführeinrichtung nach oben gerichtete Austrittsöffnungen zum nach oben Abstrahlen der Behandlungslösung aufweist.

Dadurch, dass mittels der wenigstens einen Zuführeinrichtung Behandlungslösung unter Ausbildung von Behandlungslösungsstrahlen nach oben abgestrahlt wird, lässt sich erreichen, dass an zu behandelnden Objekten, die - wie es bei einem einseitigen Behandlungsverfahren oftmals der Fall ist - oberhalb der wenigstens Zuführeinrichtung transportiert werden, frische bzw. unverbrauchte Behandlungslösung für die Behandlung der Objekte zur Verfügung steht. Ein Wärmestau und/oder eine Übersättigung mit Reaktionsprodukten im Bereich der zu behandelnden Objekte können bzw. kann auf diese Weise vermieden werden, insbesondere weil die über die wenigstens eine Zuführeinrichtung ins Becken eingebrachte Behandlungslösung Wärme und/oder Reaktionsprodukte abführen kann.

Mit nach unten ausgerichteten Austrittsöffnungen, die eine Abstrahlung von Behandlungslösungsstrahlen in Richtung des Beckenbodens bewirken, lässt sich dagegen ein Wärmestau und/oder eine Übersättigung mit Reaktionsprodukten im Bereich der zu behandelnden Objekte nicht hinreichend effektiv vermeiden.

Die Formulierung, dass die Objekte durch das Becken transportiert werden, bedeutet weder, dass sich eine Oberfläche der Objekte vollständig unterhalb eines Flüssigkeitsspiegels einer in dem Becken angeordneten Behandlungslösung befinden muss, noch, dass sich deren Oberfläche vollständig unterhalb eines Beckenrandes des Beckens befinden muss. Teile der Objektoberfläche oder die gesamte Objektoberfläche können somit grundsätzlich oberhalb des Beckenrandes des Beckens oder des Flüssigkeitsspiegels der Behandlungslösung zu liegen kommen oder transportiert werden.

Des Weiteren bedeutet die Formulierung, dass die Behandlungslösungsstrahlen nach oben abgestrahlt werden, nicht notwendigerweise, dass die Behandlungslösungsstrahlen entlang der Vertikalen abgestrahlt werden. Grundsätzlich können die nach oben abgestrahlten Behandlungslösungsstrahlen mit einer Abweichung gegenüber der Vertikalen nach oben abgestrahlt werden. Vorzugsweise beträgt die Abweichung maximal 40°, besonders bevorzugt maximal 35°.

Unter "nach oben gerichteten Austrittsöffnungen" sind Austrittsöffnungen zu verstehen, die so angeordnet sind, dass ein Fluid, wie zum Beispiel die Behandlungslösung, durch diese Austrittsöffnungen nach oben - gegebenenfalls mit einer Abweichung des zuvor genannten Ausmaßes gegenüber der Vertikalen - austreten kann.

Bei den zu behandelnden Objekten kann es sich zum Beispiel um Substrate, insbesondere um Wafer für die Solarzellen- und/oder Halbleiterindustrie, handeln.

Die zu behandelnden Objekte haben vorzugsweise eine vorgegebene Breite. Besonders bevorzugt ist es, wenn alle zu behandelnden Objekte die gleiche Breite aufweisen. Dies ermöglicht eine aufwandsgünstige Prozessierung der Objekte.

Unter der Breite eines Objekts ist dessen Erstreckung in der Transportebene sowie senkrecht zur Transportrichtung zu verstehen, wobei unter dem Begriff "Transportebene" eine Ebene zu verstehen ist, in welcher die Objekte mittels der Transportvorrichtung transportiert werden.

Vorteilhafterweise werden die Objekte mittels der Transportvorrichtung entlang einer horizontalen Transportrichtung transportiert.

Beim Transport der Objekte durch das Becken ist das Becken vorzugsweise bis zu der nach unten weisenden Oberfläche der Objekte oder darüber hinaus mit der Behandlungslösung gefüllt.

Die Behandlung der Objekte kann insbesondere eine einseitige Behandlung sein, bei welcher die nach unten weisende Oberfläche der Objekte mit der Behandlungslösung behandelt wird. Anders ausgedrückt, das Verfahren zur Behandlung der Objekte kann ein Verfahren zur einseitigen Behandlung der nach unten weisenden Oberfläche der Objekte sein. Bei einer solchen Behandlung wird die nach oben weisende Oberfläche der Objekte vorzugsweise nicht, oder zumindest nicht gezielt, mit der Behandlungslösung in Kontakt gebracht.

In dem Fall, dass es sich bei der Behandlung um eine einseitige Behandlung handelt, ist vorzugsweise vorgesehen, dass die Transportvorrichtung derart angeordnet und ausgebildet ist und das Becken derart mit der Behandlungslösung gefüllt ist, dass beim Transport nur die nach unten weisende Oberfläche der Objekte mit der Behandlungslösung in Kontakt kommt.

Ferner kann die Behandlung der Objekte beispielsweise eine Ätzbehandlung sein. In diesem Fall handelt es sich bei der Behandlungslösung zweckmäßigerweise um eine Ätzlösung. Die Behandlung kann insbesondere derart erfolgen, dass bei der Behandlung ein Ätzabtrag von mindestens 3 µm, vorzugsweise mindestens 5 µm, besonders bevorzugt mindestens 6 µm, an dem jeweiligen Objekt erzielt wird.

In einer bevorzugten Ausführungsform der Erfindung erfolgt die Behandlung der Objekte unter Ausbildung eines Meniskus der Behandlungslösung an der nach unten weisenden Oberfläche der Objekte.

Vorteilhafterweise wird während des Transports der Objekte durch das Becken ein jeder Punkt der nach unten weisenden Oberfläche der Objekte derart mit den Behandlungslösungsstrahlen in Kontakt gebracht, dass nach Durchlaufen des Beckens jeder Punkt der nach unten weisenden Oberfläche der Objekte gleich lange und eventuell gleich oft mit den Behandlungslösungsstrahlen behandelt worden ist. Dadurch kann ein homogenes Behandlungsergebnis auf der nach unten weisenden Oberfläche der Objekte erzielt werden.

In bevorzugter Weise werden die Behandlungslösungsstrahlen in bereits in dem Becken enthaltener Behandlungslösung ausgebildet. Die Behandlungslösungsstrahlen bewirken dabei vorteilhafterweise eine Umwälzung der bereits in dem Becken enthaltenen Behandlungslösung.

Beim Durchtritt durch die bereits in dem Becken enthaltene Behandlungslösung können sich die Behandlungslösungsstrahlen kegelförmig aufweiten. In diesem Fall kann die Formulierung, dass die Behandlungslösung mittels der nach oben gerichteten Austrittsöffnungen unter Ausbildung von Behandlungslösungsstrahlen nach oben abgestrahlt wird, so verstanden werden, dass die Kegelachse des jeweiligen abgestrahlten Behandlungslösungsstrahls eine Abweichung von vorzugsweise maximal 40°, besonders bevorzugt maximal 35°, gegenüber der Vertikalen aufweist.

Die wenigstens eine Zuführeinrichtung ist als Rohr-in-Rohr-System mit einem äußeren Rohr und einem in dem äußeren Rohr angeordneten inneren Rohr ausgebildet. Die Behandlungslösung wird über nach unten gerichtete Austrittsöffnungen des inneren Rohrs in das äußere Rohr eingeleitet. Ferner werden die Behandlungslösungsstrahlen aus dem äußeren Rohr nach oben in das Becken abgestrahlt.

Nach unten gerichtete Austrittsöffnungen des inneren Rohrs ermöglichen es, dass sich gasblasenreiche Behandlungslösung im oberen Teil des inneren Rohrs sammeln kann. Von dort kann die gasblasenreiche Behandlungslösung oder gezielt nur das angesammelte Gas aus dem inneren Rohr abgeführt werden, beispielsweise über eine mit dem inneren Rohr verbundene Abführleitung. Auf diese Weise lässt sich erreichen, dass die aus dem inneren Rohr in das äußere Rohr eingeleitete Behandlungslösung gasblasenarm oder gasblasenfrei ist. Dies hat insbesondere bei einer einseitigen Behandlung der Objekte den Vorteil, dass eine Kontaminierung der nach oben weisenden Oberfläche der Objekte mit der Behandlungslösung, die zum Beispiel auf platzende Gasblasen zurückführbar ist, vermieden werden kann.

Durch eine Kombination von nach unten gerichteten Austrittsöffnungen bei dem inneren Rohr und nach oben gerichteten Austrittsöffnungen bei dem äußeren Rohr kann eine "Labyrinthwirkung" erreicht werden, die ein verbessertes Ausströmverhalten der Behandlungslösung aus der wenigstens einen Zuführeinrichtung ermöglicht. Insbesondere kann durch die Einleitung der Behandlungslösung in das äußere Rohr über nach unten gerichtete Austrittsöffnungen des inneren Rohrs und die Abstrahlung der Behandlungslösungsstrahlen aus dem äußeren Rohr eine homogenere Ausströmung der Behandlungslösung aus der wenigstens einen Zuführeinrichtung erzielt werden.

Besonders bevorzugt ist es, wenn das innere Rohr ausschließlich nach unten gerichtete Austrittsöffnungen zur Einleitung der Behandlungslösung in das äußere Rohr aufweist.

Zweckmäßigerweise ist die wenigstens eine Zuführeinrichtung unterhalb der Transportvorrichtung angeordnet. Vorzugsweise ist die wenigstens eine Zuführeinrichtung horizontal ausgerichtet.

Bei einer vorteilhaften Ausgestaltung der Erfindung erstreckt sich die wenigstens eine Zuführeinrichtung in dem Becken zumindest abschnittsweise, vorzugsweise vollständig, nicht parallel zur Transportrichtung. Mit anderen Worten, es ist vorteilhaft, wenn sich zumindest ein Teilabschnitt der wenigstens einen Zuführeinrichtung nicht parallel zur Transportrichtung erstreckt.

Des Weiteren kann vorgesehen sein, dass die wenigstens eine Zuführeinrichtung zumindest abschnittsweise eine gerade Erstreckung aufweist, welche schräg zur Transportrichtung ausgerichtet ist. Mit anderen Worten, zumindest ein Teilabschnitt der wenigstens einen Zuführeinrichtung kann eine gerade, schräg zur Transportrichtung ausgerichtete Erstreckung aufweisen. In bevorzugter Weise erstreckt sich besagte gerade Erstreckung über die gesamte Länge der wenigstens einen Zuführeinrichtung.

Vorteilhafterweise sind mittels der nach oben gerichteten Austrittsöffnungen der wenigstens einen Zuführeinrichtung sich kegelförmig aufweitende Behandlungslösungsstrahlen ausbildbar.

In dem Fall, dass sich besagte gerade Erstreckung über die gesamte Länge der wenigstens einen Zuführeinrichtung erstreckt, ist es vorteilhaft, wenn die gerade Erstreckung in einem Winkel α zu der Transportrichtung ausgerichtet ist, für den zumindest näherungsweise gilt α = arcsin((B - 2R)/L). Dabei steht L für die Länge der wenigstens einen Zuführeinrichtung, B für die Breite der zu behandelnden Objekte und R für den Radius der Behandlungslösungsstrahlen auf Höhe der Transportebene der Transportvorrichtung. Insbesondere mit einer solchen Ausrichtung der wenigstens einen Zuführeinrichtung bezüglich der Transportrichtung kann erreicht werden, dass bei Durchlaufen des Beckens ein jeder Punkt der nach unten weisenden Oberfläche der Objekte gleich lange mit den Behandlungslösungsstrahlen behandelt wird.

Der Ausdruck "zumindest näherungsweise" meint dabei, dass α exakt gleich arcsin((B - 2R)/L) sein kann oder geringfügig, beispielsweise um höchstens 10%, vorzugsweise um höchstens 5%, von diesem Term abweichen kann.

Alternativ kann vorgesehen sein, dass die wenigstens eine Zuführeinrichtung parallel zur Transportebene und senkrecht zur Transportrichtung eine Periodizität aufweist oder Sprünge enthält. Zum Beispiel kann die wenigstens eine Zuführeinrichtung einen Zick-Zack-Verlauf aufweisen. Auch ist eine "unterbrochene" Ausgestaltung der Zuführeinrichtung möglich, bei der die Zuführeinrichtung mehrere, insbesondere voneinander beabstandete Teilstücke umfasst, die schräg zur Transportrichtung angeordnet sind.

Einer vorteilhaften Ausführungsform der Erfindung weist die wenigstens eine Zuführeinrichtung mehrere nach oben gerichtete Austrittsöffnungen auf, welche in einer Längserstreckungsrichtung der wenigstens einen Zuführeinrichtung beabstandet voneinander angeordnet sind.

Wie zuvor erwähnt, ist die wenigstens eine Zuführeinrichtung als Rohr-in-Rohr-System ausgebildet. Das äußere Rohr weist die nach oben gerichteten Austrittsöffnungen zum nach oben Abstrahlen der Behandlungslösung auf. Das innere Rohr weist nach unten gerichtete Austrittsöffnungen auf, über welche die Behandlungslösung in das äußere Rohr einleitbar ist.

Zweckmäßigerweise umfasst die Behandlungsvorrichtung mindestens einen Abstandhalter, der zwischen dem inneren Rohr und dem äußeren Rohr angeordnet ist. Ein solcher Abstandhalter dient vorzugsweise dazu, die beiden Rohre in einem vorgegebenen Abstand zueinander zu halten. Weiter ist es zweckmäßig, wenn ein Spalt zwischen dem inneren Rohr und dem äußeren Rohr mittels eines oder mehrerer Dichtelemente abgedichtet ist.

Unter einem Rohr ist vorliegend nicht notwendigerweise ein Hohlkörper mit einer kreisrunden Querschnittsform zu verstehen. Das jeweilige Rohr kann beispielsweise eine eckige, insbesondere dreieckige oder viereckige, Querschnittsform oder eine runde, insbesondere kreisrunde, elliptische oder ovale, Querschnittsform aufweisen. Ferner müssen das innere und das äußere Rohr nicht notwendigerweise eine gleichartige Querschnittsform aufweisen. Zum Beispiel kann das innere Rohr eine runde Querschnittsform aufweisen, während das äußere Rohr eine rechteckige Querschnittsform aufweist.

Insbesondere im Falle einer Ausgestaltung des äußeren Rohrs mit einer rechteckigen Querschnittsform kann das äußere Rohr so breit wie die zu behandelnden Objekte sein und parallel zur Transportrichtung ausgerichtet sein. Die nach oben gerichteten Austrittsöffnungen des äußeren Rohrs können dabei derart verteilt sein, dass im Betrieb der Vorrichtung bzw. bei der Durchführung des Verfahrens die nach unten weisende Oberfläche der Objekte durch die Behandlungslösungsstrahlen gleichmäßig mit der Behandlungslösung beaufschlagt wird.

Zusätzlich zu den nach oben gerichteten Austrittsöffnungen kann die wenigstens eine Zuführeinrichtung nach unten gerichtete und/oder seitliche Austrittsöffnungen zum nach unten Abstrahlen und/oder zum seitlichen Abstrahlen der Behandlungslösung aufweisen. Dies ermöglicht eine gleichmäßigere Umwälzung der Behandlungslösung im Becken. Insbesondere kann das äußere Rohr diese nach unten gerichteten und/oder seitlichen Austrittsöffnungen aufweisen.

Unter "nach unten gerichteten Austrittsöffnungen" sind Austrittsöffnungen zu verstehen, die so angeordnet sind, dass ein Fluid, wie zum Beispiel die Behandlungslösung, durch diese Austrittsöffnungen nach unten - gegebenenfalls mit einer Abweichung gegenüber der Vertikalen - austreten kann. Vorzugsweise beträgt die Abweichung maximal 40°, besonders bevorzugt maximal 35°.

Unter "seitlichen Austrittsöffnungen" sind Austrittsöffnungen zu verstehen, die so angeordnet sind, dass ein Fluid, wie zum Beispiel die Behandlungslösung, durch diese Austrittsöffnungen seitlich - gegebenenfalls mit einer Abweichung gegenüber der Horizontalen - austreten kann. Vorzugsweise beträgt die Abweichung dabei maximal 40°, besonders bevorzugt maximal 35°.

Bei einer vorteilhaften Ausführungsform weist die wenigstens eine Zuführeinrichtung mehrere schräg oder senkrecht zur Transportrichtung nebeneinander angeordnete nach oben ausgerichtete Austrittsöffnungen zum nach oben Abstrahlen der Behandlungslösung auf. Auf diese Weise kann eine räumlich weiter ausgedehnte Abstrahlung der Behandlungslösung ins Becken und damit eine gleichmäßigere Umwälzung der Behandlungslösung im Becken erreicht werden. Insbesondere kann das äußere Rohr diese schräg oder senkrecht zur Transportrichtung nebeneinander angeordneten Austrittsöffnungen aufweisen.

In bevorzugter Weise umfasst die Transportvorrichtung mehrere in Transportrichtung hintereinander angeordnete Transportrollen. Ferner ist es bevorzugt, wenn die wenigstens eine Zuführeinrichtung unterhalb der Transportrollen der Transportvorrichtung angeordnet ist.

Vorteilhafterweise sind die nach oben gerichteten Austrittsöffnungen der wenigstens einen Zuführeinrichtung, bezogen auf die Transportrichtung, an den Positionen der Transportrollen angeordnet. Das heißt, von oben betrachtet sind die Austrittsöffnungen der wenigstens einen Zuführeinrichtung durch die Transportrollen verdeckt. Auf diese Weise kann erreicht werden, dass die Transportrollen von den Behandlungslösungsstrahlen zumindest abschnittsweise umströmt werden, wodurch eine bessere Umwälzung der Behandlungslösung im Bereich der Transportrollen erreicht werden kann.

Die Transportrollen der Transportvorrichtung können insbesondere derart angeordnet sein, dass deren oberster Punkt jeweils auf Höhe des Beckenrands angeordnet ist.

Zweckmäßigerweise weist die Behandlungsvorrichtung eine Versorgungseinrichtung zum Einleiten der Behandlungslösung in die wenigstens eine Zuführeinrichtung auf. Die Versorgungseinrichtung kann unter anderem eine mit der wenigstens einen Zuführeinrichtung verbundene Versorgungsleitung umfassen. Insbesondere kann das innere Rohr mit der Versorgungsleitung verbunden sein.

Bei einer bevorzugten Ausgestaltung der Erfindung weist die Behandlungsvorrichtung eine Entgasungsvorrichtung zum Entfernen von Gasblasen und/oder gasblasenreicher Behandlungslösung aus der wenigstens einen Zuführeinrichtung auf. Die Entgasungsvorrichtung kann unter anderem eine Abführleitung aufweisen, welche mit der wenigstens einen Zuführeinrichtung verbunden ist. Insbesondere kann das innere Rohr mit der Abführleitung verbunden sein.

Mittels der Entgasungsvorrichtung kann bei der Durchführung des Verfahrens gasblasenreiche Behandlungslösung oder gezielt nur das angesammelte Gas aus der wenigstens einen Zuführeinrichtung abgeführt werden. Wird gasblasenreiche Behandlungslösung aus der wenigstens einen Zuführeinrichtung abgeführt, kann nach einer Entfernung der Gasblasen aus der gasblasenreichen Behandlungslösung die Behandlungslösung wieder in die wenigstens eine Zuführeinrichtung eingeleitet werden.

Vorteilhafterweise ist die Behandlungsvorrichtung dazu eingerichtet, die zu behandelnden Objekte in mehreren Spuren nebeneinander entlang der Transportrichtung zu transportieren. Dadurch lässt sich ein hoher Durchsatz mit der Behandlungsvorrichtung erreichen. Die Behandlungsvorrichtung kann zum Beispiel derart ausgebildet sein, dass sie einen Durchsatz von mindestens 500 Objekten pro Spur und Stunde, vorzugsweise mindestens 700 Objekten pro Spur und Stunde, besonders bevorzugt mindestens 900 Objekten pro Stunde, realisieren kann. Beispielsweise kann die Behandlungsvorrichtung dazu eingerichtet sein, die zu behandelnden Objekte in fünf Spuren nebeneinander entlang der Transportrichtung zu transportieren und einen Durchsatz von 1000 Objekten pro Spur und Stunde zu realisieren.

Die wenigstens eine Zuführeinrichtung kann eine von mehreren, insbesondere baugleich ausgebildeten Zuführeinrichtungen sein. Ferner kann die Behandlungsvorrichtung für jede Spur jeweils eine eigene Zuführeinrichtung aufweisen.

Vorteilhafterweise ist jede der Zuführeinrichtungen an die zuvor erwähnte Abführleitung der Entgasungsvorrichtung angeschlossen. Des Weiteren ist es zweckmäßig, wenn jede der Zuführeinrichtungen an die zuvor erwähnte Versorgungsleitung der Versorgungseinrichtung angeschlossen ist.

Im Weiteren wird die Erfindung anhand von Figuren näher erläutert. Soweit zweckdienlich, sind hierbei gleiche oder gleichwirkende Elemente mit gleichen Bezugszeichen versehen. Die Erfindung ist nicht auf die in den Figuren dargestellten Ausführungen beschränkt - auch nicht in Bezug auf funktionale Merkmale. Die bisherige Beschreibung und die nachfolgende Figurenbeschreibung enthalten zahlreiche Merkmale, die in den abhängigen Ansprüchen teilweise zu mehreren zusammengefasst wiedergegeben sind. Diese Merkmale wird der Fachmann jedoch auch einzeln betrachten und zu sinnvollen weiteren Kombinationen zusammenfügen. Insbesondere sind diese Merkmale jeweils einzeln und in beliebiger geeigneter Kombination mit dem erfindungsgemäßen Verfahren und/oder der erfindungsgemäßen Behandlungsvorrichtung kombinierbar.

Es zeigen:
- Figur 1: ein Ausführungsbeispiel einer erfindungsgemäßen Behandlungsvorrichtung zur Durchführung des erfindungsgemäßen Verfahrens in einer Draufsicht;
- Figur 2: einen Schnitt durch die Behandlungsvorrichtung entlang der Schnittebene A-A aus Figur 1;
- Figur 3: eine Draufsicht einer Zuführeinrichtung der Behandlungsvorrichtung;
- Figur 4: eine Seitenansicht der Zuführeinrichtung aus Figur 3;
- Figur 5: einen Schnitt durch die Zuführeinrichtung entlang der Schnittebene B-B aus Figur 4 (Längsschnitt);
- Figur 6: einen Schnitt durch die Zuführeinrichtung entlang der Schnittebene C-C aus Figur 4 (Querschnitt);
- Figur 7: einen vergrößerten Ausschnitt der Schnittdarstellung aus Figur 5 (Detail-Längsschnitt).

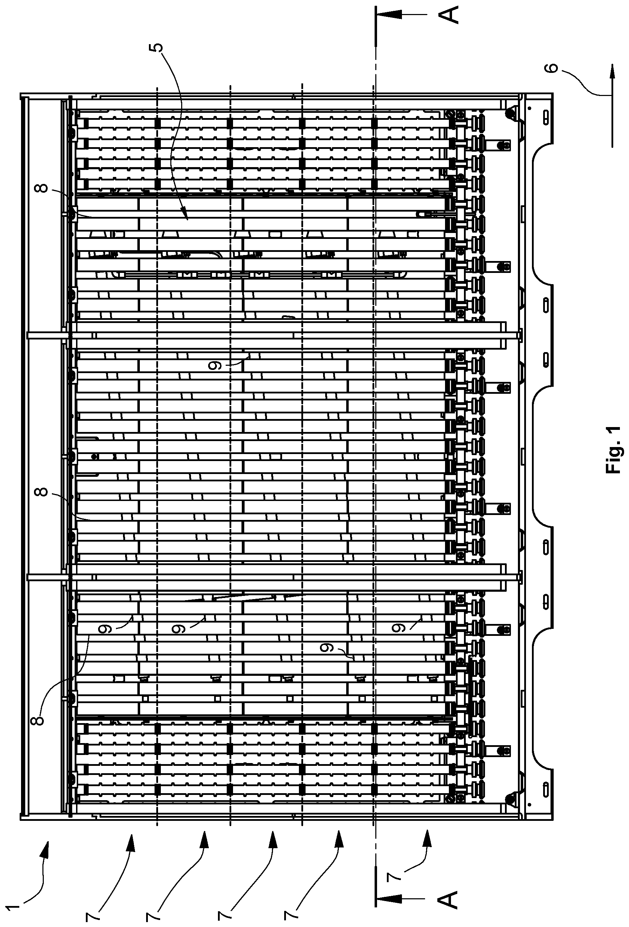

Figur 1 zeigt ein Ausführungsbeispiel einer erfindungsgemäßen Behandlungsvorrichtung 1 zur einseitigen Behandlung von Objekten 2 in einer Ansicht von oben.

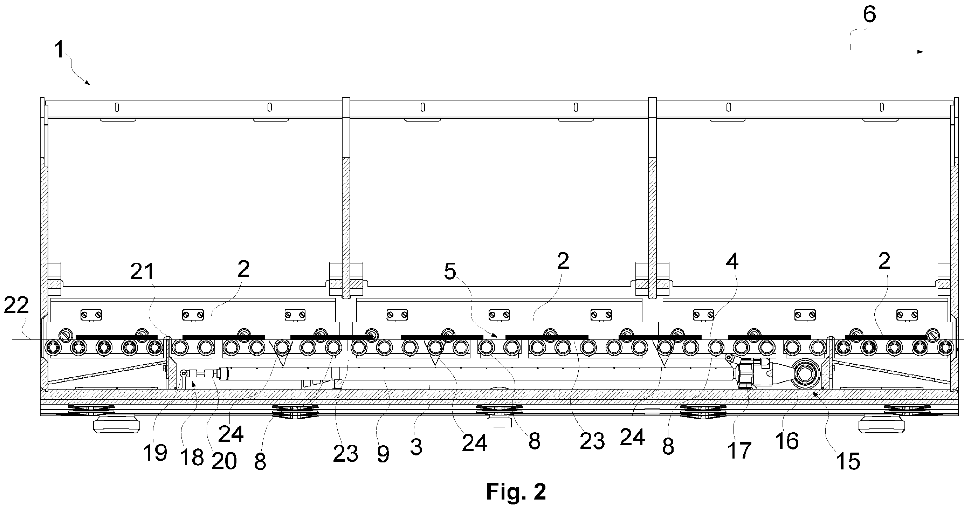

Bei den zu behandelnden Objekten 2 (vgl. Figur 2) kann es sich beispielsweise um Substrate, insbesondere um Wafer für die Solarzellen- und/oder Halbleiterindustrie, handeln, wobei die Objekte 2 in Figur 1 einer besseren Übersichtlichkeit halber nicht dargestellt sind.

Die Behandlungsvorrichtung 1 umfasst ein Becken 3 zur Aufnahme einer Behandlungslösung 4, wie zum Beispiel einer Ätzlösung (vgl. Figur 2). Ferner umfasst die Behandlungsvorrichtung 1 eine Transportvorrichtung 5, mittels welcher die zu behandelnden Objekte 2 entlang einer horizontalen Transportrichtung 6 durch das Becken 3 transportierbar sind.

Des Weiteren ist die Behandlungsvorrichtung 1 dazu eingerichtet, die zu behandelnden Objekte 2 mittels der Transportvorrichtung 5 in mehreren Spuren 7 nebeneinander entlang der Transportrichtung 6 zu transportieren. In Figur 1 kennzeichnen gestrichelte Linien die seitlichen Ränder der jeweiligen Spur 7.

Wie aus Figur 1 ersichtlich ist, umfasst die Transportvorrichtung 5 mehrere in Transportrichtung 6 hintereinander angeordnete Transportrollen 8 zum Transportieren der Objekte 2. Die Transportrollen 8 sind senkrecht zur Transportrichtung 6 ausgerichtet und vorzugsweise äquidistant zueinander angeordnet.

Außerdem weist die Behandlungsvorrichtung 1 mehrere Zuführeinrichtungen 9 auf, mittels welcher Behandlungslösung 4 in das Becken 3 einleitbar ist. Die Zuführeinrichtungen 9 sind unterhalb der Transportrollen 8 angeordnet. Zudem sind die Zuführeinrichtungen 9 vorzugsweise auf gleicher Höhe, parallel zueinander sowie äquidistant zueinander angeordnet. Für jede der Spuren 7 weist die Behandlungsvorrichtung 1 jeweils eine eigene Zuführeinrichtung 9 auf. Da die Behandlungsvorrichtung 1 im vorliegenden Ausführungsbeispiel dazu eingerichtet ist, die zu behandelnden Objekte 2 mittels der Transportvorrichtung 5 in fünf Spuren 7 nebeneinander zu transportieren, weist die Behandlungsvorrichtung 1 entsprechend fünf Zuführeinrichtungen 9 auf.

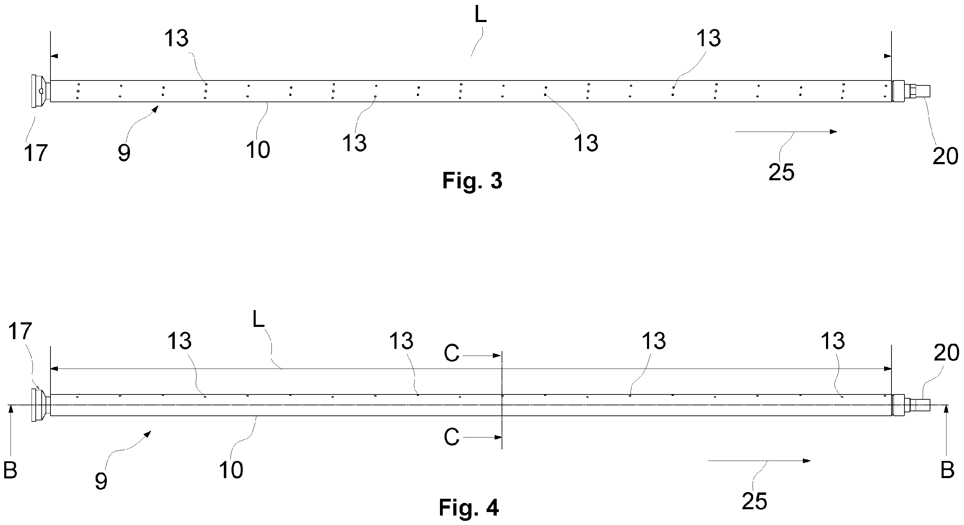

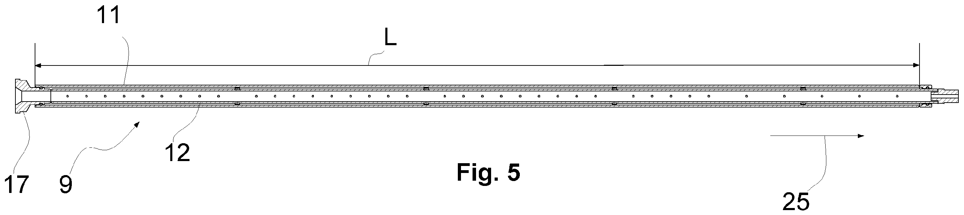

Die jeweilige Zuführeinrichtung 9 weist eine gerade Erstreckung 10 auf, die sich über die gesamte Länge L der jeweiligen Zuführeinrichtung 9 erstreckt (vgl. Figuren 3 bis 5), und ist schräg zur Transportrichtung 6 ausgerichtet. Zudem ist jede der Zuführeinrichtungen 9 als Rohr-in-Rohr-System mit einem äußeren Rohr 11 und einem in dem äußeren Rohr 11 angeordneten inneren Rohr 12 ausgebildet (vgl. Figuren 5 bis 7).

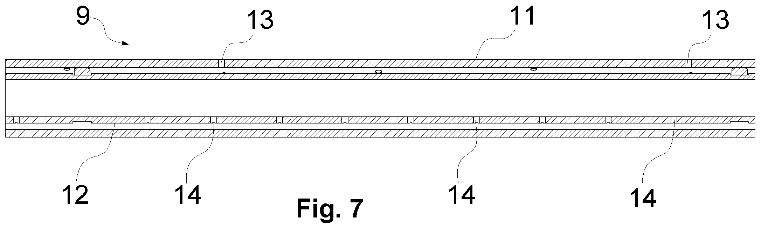

Das äußere Rohr 11 der jeweiligen Zuführeinrichtung 9 weist mehrere nach oben ausgerichtete Austrittsöffnungen 13 zum nach oben Abstrahlen der Behandlungslösung 4 auf (vgl. insbesondere Figuren 3, 4, 6 und 7). Die Austrittsöffnungen 13 sind jeweils, bezogen auf die Transportrichtung 6, an den Positionen der Transportrollen 8 angeordnet, wobei das jeweilige äußere Rohr 11 bei jeder Transportrolle 8 mehrere nebeneinander angeordnete nach oben ausgerichtete Austrittsöffnungen 13 aufweist. Da die Transportrollen 8 oberhalb der Zuführeinrichtungen 9 angeordnet sind, sind die Austrittsöffnungen 13 des jeweiligen äußeren Rohrs 11 in Figur 1 durch die Transportrollen 8 verdeckt und somit nicht sichtbar. Das innere Rohr 12 der jeweiligen Zuführeinrichtung 9 weist mehrere nach unten ausgerichtete Austrittsöffnungen 14 zum Einleiten der Behandlungslösung 4 in das zugehörige äußere Rohr 11 auf (vgl. Figur 7). Weiter umfasst die Behandlungsvorrichtung 1 eine Versorgungseinrichtung 15 zum Einleiten der Behandlungslösung 4 in das innere Rohr 12 der jeweiligen Zuführeinrichtung 9. Die Versorgungseinrichtung 15 umfasst eine Versorgungsleitung 16, an welche die Zuführeinrichtungen 9, genauer gesagt die inneren Rohre 12 der Zuführeinrichtungen 9, jeweils mittels einer Anschlusseinheit 17 angeschlossen sind (vgl. Figur 2).

Darüber hinaus umfasst die Behandlungsvorrichtung 1 eine Entgasungsvorrichtung 18 zum Entfernen von Gasblasen und/oder gasblasenreicher Behandlungslösung aus den Zuführeinrichtungen 9. Die Entgasungsvorrichtung 18 weist eine Abführleitung 19 auf, an welche die Zuführeinrichtungen 9, genauer gesagt die inneren Rohre 12 der Zuführeinrichtungen 9, jeweils mittels einer Anschlusseinheit 20 angeschlossen sind (vgl. Figur 2).

Figur 2 zeigt einen Schnitt durch die Behandlungsvorrichtung 1 entlang der Schnittebene A-A aus Figur 1.

Aus Figur 2 ist ersichtlich, dass die Transportrollen 8 der Transportvorrichtung 5 auf gleicher Höhe angeordnet sind. Im vorliegenden Ausführungsbeispiel sind die Transportrollen 8 derart angeordnet, dass deren oberster Punkt jeweils auf Höhe eines Beckenrands 21 des Beckens 3 angeordnet ist. Das heißt, die Transportebene 22, in welcher die Objekte 2 mittels der Transportvorrichtung 5 transportiert werden, befindet sich auf Höhe des Beckenrands 21. Dadurch wird erreicht, dass auf den Transportrollen 8 transportierte Objekte 2 nur an ihrer nach unten weisenden Oberfläche 23 mit der Behandlungslösung 4, mit welcher das Becken 3 bis zu seinem Beckenrand 21 gefüllt ist, in Kontakt kommen.

Die Behandlung der Objekte 2 mittels der Behandlungslösung 4 erfolgt während des Transports der Objekte 2 durch das Becken 3. Bei der Behandlung kommen die Objekte 2 an ihrer nach unten weisenden Oberfläche 23 mit der Behandlungslösung 4 in Kontakt.

Über die Versorgungsleitung 16 der Versorgungseinrichtung 15 wird Behandlungslösung 4 in die inneren Rohre 12 der Zuführeinrichtungen 9 eingeleitet. Aus dem inneren Rohr 12 der jeweiligen Zuführeinrichtung 9 wird die Behandlungslösung 4 über dessen nach unten gerichteten Austrittsöffnungen 14 in das zugehörige äußere Rohr 11 eingeleitet. Aus dem äußeren Rohr 11 der jeweiligen Zuführeinrichtung 9 wiederum wird die Behandlungslösung 4 über dessen nach oben gerichtete Austrittsöffnungen 13 unter Ausbildung von Behandlungslösungsstrahlen 24, von denen in Figur 2 exemplarisch einige schematisch dargestellt sind, nach oben abgestrahlt.

Die Behandlungslösungsstrahlen 24 bilden sich in der bereits in dem Becken 3 enthaltenen Behandlungslösung 4 und kommen mit den zu behandelnden Objekten 2 in Kontakt. Beim Durchtritt durch die bereits in dem Becken 3 enthaltene Behandlungslösung 4 weiten sich die Behandlungslösungsstrahlen 24 kegelförmig auf.

Wie zuvor erwähnt ist die jeweilige Zuführeinrichtung 9 schräg zur Transportrichtung 6 ausgerichtet. Für den Winkel α, in dem die jeweilige Zuführeinrichtung 9 zur Transportrichtung 6 steht, gilt zumindest näherungsweise α = arcsin((B - 2R)/L), wobei L die Länge der jeweiligen Zuführeinrichtung 9 ist, B die Breite der zu behandelnden Objekte 2 ist und R der Radius der Behandlungslösungsstrahlen 24 auf Höhe der Transportebene 22 ist. Insbesondere durch eine solche Ausrichtung der Zuführeinrichtungen 9 relativ zur Transportrichtung 6 kann erreicht werden, dass während des Transports der Objekte 2 durch das Becken 3 ein jeder Punkt der nach unten weisenden Oberfläche 23 der Objekte 2 derart mit den Behandlungslösungsstrahlen 24 in Kontakt gebracht wird, dass nach Durchlaufen des Beckens 3 jeder Punkt der nach unten weisenden Oberfläche 23 der Objekte 2 gleich lange mit den Behandlungslösungsstrahlen 24 behandelt worden ist.

Gasblasen, die in der den inneren Rohren 12 der Zuführeinrichtungen 9 zugeleiteten Behandlungslösung 4 enthalten sind, sammeln sich im oberen Teil des jeweiligen inneren Rohrs 12. Über die mit den inneren Rohren 12 der Zuführeinrichtung 9 verbundene Abführleitung 19 der Entgasungsvorrichtung 18 kann gasblasenreiche Behandlungslösung oder gegebenenfalls nur das angesammelte Gas abgeführt werden. Über die nach unten gerichteten Austrittsöffnungen 14 des jeweiligen inneren Rohrs 12 tritt nur gasblasenarme oder gasblasenfreie Behandlungslösung 4 in das zugehörige äußere Rohr 11 aus, sodass aus Letzterem nur gasblasenarme oder gasblasenfreie Behandlungslösung 4 nach oben abgestrahlt wird. Auf diese Weise wird der Eintrag von Gasblasen in die im Becken 3 befindliche Behandlungslösung 4 vermieden oder zumindest reduziert.

Figur 3 zeigt exemplarisch eine Draufsicht einer der Zuführeinrichtungen 9 der Behandlungsvorrichtung 1. Da die Zuführeinrichtungen 9 der Behandlungsvorrichtung 1 zueinander baugleich ausgebildet sind, gelten die nachfolgenden Ausführungen analog auch für die anderen Zuführeinrichtungen 9 der Behandlungsvorrichtung 1.

In Figur 3 sind die nach oben gerichteten Austrittsöffnungen 13 der dargestellten Zuführeinrichtung 9, genauer gesagt ihres äußeren Rohrs 11 (vgl. Figur 5), sichtbar. Die nach oben gerichteten Austrittsöffnungen 13 der Zuführeinrichtung 9 sind, wie aus Figur 3 ersichtlich ist, in Längserstreckungsrichtung 25 der Zuführeinrichtung 9 im Wesentlichen über die gesamte Länge L der Zuführeinrichtung 9 verteilt.

Ferner sind in Figur 3 zwei Anschlusseinheiten 17, 20 abgebildet, mittels welcher die Zuführeinrichtung 9 in der Behandlungsvorrichtung 1 an die Abführleitung 19 der Entgasungsvorrichtung 18 bzw. an die Versorgungsleitung 16 der Versorgungseinrichtung 15 angeschlossen ist. Die Anschlusseinheit 20, mittels welcher die Zuführeinrichtung 9 an die Abführleitung 19 der Entgasungsvorrichtung 18 angeschlossen ist, ist in Figur 3 am rechten Ende der Zuführeinrichtung 9 angeordnet, wohingegen die Anschlusseinheit 17, mittels welcher die Zuführeinrichtung 9 an die Versorgungsleitung 16 der Versorgungseinrichtung 15 angeschlossen ist, am linken Ende der Zuführeinrichtung 9 angeordnet ist.

Figur 4 zeigt eine Seitenansicht der Zuführeinrichtung 9 aus Figur 3. Außerdem sind in Figur 4 auch noch die beiden besagten Anschlusseinheiten 17, 20 dargestellt.

Ferner sind in Figur 4 zwei Schnittebenen (Schnittebenen B-B und C-C) eingezeichnet, auf welche sich die Schnittdarstellungen der Figuren 5 bis 7 beziehen.

Figur 5 zeigt einen Schnitt durch die Zuführeinrichtung 9 aus Figur 3 sowie durch die an dieser Zuführeinrichtung 9 angeordneten Anschlusseinheiten 17, 20 entlang der Schnittebene B-B.

In Figur 5 ist außer dem (in Figur 3 und Figur 4 bereits sichtbaren) äußeren Rohr 11 der Zuführeinrichtung 9 auch deren inneres Rohr 12 sichtbar.

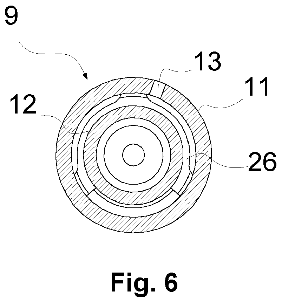

Figur 6 zeigt einen Schnitt durch die Zuführeinrichtung 9 aus Figur 3 entlang der Schnittebene C-C.

In Figur 6 sind das äußere Rohr 11 und das innere Rohr 12 der Zuführeinrichtung 9 im Querschnitt abgebildet. Auf der 1-Uhr-Position ist eine der nach oben gerichteten Austrittsöffnungen 13 des äußeren Rohrs 11 zu sehen. Darüber hinaus ist in Figur 6 ein zwischen dem inneren Rohr 12 und dem äußeren Rohr 11 angeordneter Abstandshalter 26 sichtbar, der die beiden Rohre 11, 12 der Zuführeinrichtung 9 in einem vorgegebenen Abstand zueinander hält.

Figur 7 zeigt einen vergrößerten Ausschnitt der Schnittdarstellung aus Figur 5.

In Figur 7 sind ein Teil des inneren Rohrs 12 sowie ein Teil des äußeren Rohrs 11 der Zuführeinrichtung 9 dargestellt, wobei mehrere der nach unten ausgerichteten Austrittsöffnungen 14 des inneren Rohrs 12 sowie einige der nach oben ausgerichteten Austrittsöffnungen 13 des äußeren Rohrs 11 sichtbar sind.

Durch die nach unten gerichteten Austrittsöffnungen 14 des inneren Rohrs 12 wird die Behandlungslösung 4 unter Separierung von Gasblasen in das äußere Rohr 11, genauer gesagt in den Spalt zwischen dem inneren Rohr 12 und dem äußeren Rohr 11, eingeleitet. Die Gasblasen sammeln sich im oberen Teil des inneren Rohrs 11. Zu den nach oben gerichteten Austrittsöffnungen 13 gelangt somit gasblasenarme oder gasblasenfreie Behandlungslösung 4.

Die Erfindung wurde anhand des dargestellten Ausführungsbeispiels detailliert beschrieben. Dennoch ist die Erfindung nicht auf oder durch das offenbarte Beispiel beschränkt. Andere Varianten können vom Fachmann aus diesem Ausführungsbeispiel abgeleitet werden, ohne von den der Erfindung zugrunde liegenden Gedanken abzuweichen. Der Schutzumfang des Patents wird durch die Patentansprüche festgelegt.

### Bezugszeichenliste

- 1: Behandlungsvorrichtung
- 2: Objekt
- 3: Becken
- 4: Behandlungslösung
- 5: Transportvorrichtung
- 6: Transportrichtung
- 7: Spur
- 8: Transportrolle
- 9: Zuführeinrichtung
- 10: gerade Erstreckung
- 11: äußeres Rohr
- 12: inneres Rohr
- 13: nach oben gerichtete Austrittsöffnung
- 14: nach unten gerichtete Austrittsöffnung
- 15: Versorgungseinrichtung
- 16: Versorgungsleitung
- 17: Anschlusseinheit
- 18: Entgasungseinrichtung
- 19: Abführleitung
- 20: Anschlusseinheit
- 21: Beckenrand
- 22: Transportebene
- 23: nach unten weisende Oberfläche
- 24: Behandlungslösungsstrahl
- 25: Längserstreckungsrichtung
- 26: Abstandshalter
- L: Länge

## Patentansprüche

1. Verfahren zur Behandlung von Objekten (2), bei welchem
- zu behandelnde Objekte (2) mittels einer Transportvorrichtung (5) durch ein Becken (3) transportiert werden;
- mittels wenigstens einer mit nach oben gerichteten Austrittsöffnungen (13) versehenen Zuführeinrichtung (9) Behandlungslösung (4) in das Becken (3) eingeleitet wird und die Behandlungslösung (4) dabei mittels der nach oben gerichteten Austrittsöffnungen (13) unter Ausbildung von Behandlungslösungsstrahlen (24) nach oben abgestrahlt wird;
- wobei die Objekte (2) oberhalb der nach oben gerichteten Austrittsöffnungen (13) durch das Becken (3) transportiert werden;
- während des Transports der Objekte (2) durch das Becken (3) eine nach unten weisende Oberfläche (23) der Objekte (2) mit den Behandlungslösungsstrahlen (24) in Kontakt gebracht wird;
- die wenigstens eine Zuführeinrichtung (9) als Rohr-in-Rohr-System mit einem äußeren Rohr (11) und einem im äußeren Rohr (11) angeordneten inneren Rohr (12) ausgebildet ist, wobei die Behandlungslösung (4) über nach unten gerichtete Austrittsöffnungen (14) des inneren Rohrs (12) in das äußere Rohr (11) eingeleitet wird und die Behandlungslösungsstrahlen (24) aus dem äußeren Rohr (11) nach oben in das Becken (3) abgestrahlt werden.

2. Verfahren nach Anspruch 1,
**dadurch gekennzeichnet,**
**dass** die Behandlung eine einseitige Behandlung ist, bei welcher die nach unten weisende Oberfläche (23) der Objekte (2) mit der Behandlungslösung (4) behandelt wird.

3. Verfahren nach Anspruch 1 oder 2,
**dadurch gekennzeichnet,**
**dass** während des Transports der Objekte (2) durch das Becken (3) ein jeder Punkt der nach unten weisenden Oberfläche (23) der Objekte (2) derart mit den Behandlungslösungsstrahlen (24) in Kontakt gebracht wird, dass nach Durchlaufen des Beckens (3) jeder Punkt der nach unten weisenden Oberfläche (23) der Objekte (2) gleich lange mit den Behandlungslösungsstrahlen (24) behandelt worden ist.

4. Verfahren nach einem der voranstehenden Ansprüche,
**dadurch gekennzeichnet,**
**dass** die Behandlungslösungsstrahlen (24) in bereits in dem Becken (3) enthaltener Behandlungslösung (4) ausgebildet werden.

5. Behandlungsvorrichtung (1) zur Durchführung eines Verfahrens nach einem der voranstehenden Ansprüche, umfassend
- ein Becken (3), in welchem eine Behandlungslösung (4) anordenbar ist;
- eine Transportvorrichtung (5), mittels welcher zu behandelnde Objekte (2) in einer Transportrichtung (6) durch das Becken (3) transportierbar sind;
- wenigstens eine in dem Becken (3) angeordnete Zuführeinrichtung (9), mittels welcher Behandlungslösung (4) in das Becken (3) einleitbar ist;
- wobei die wenigstens eine Zuführeinrichtung (9) nach oben gerichtete Austrittsöffnungen (13) zum nach oben Abstrahlen der Behandlungslösung (4) aufweist, wobei die wenigstens eine Zuführeinrichtung (9) als Rohr-in-Rohr-System mit einem äußeren Rohr (11) und einem im äußeren Rohr (11) angeordneten inneren Rohr (12) ausgebildet ist, wobei das äußere Rohr (11) die nach oben gerichteten Austrittsöffnungen (13) zum nach oben Abstrahlen der Behandlungslösung (4) aufweist und das innere Rohr (12) nach unten gerichtete Austrittsöffnungen (14) aufweist, über welche die Behandlungslösung (4) in das äußere Rohr (12) einleitbar ist.

6. Behandlungsvorrichtung (1) nach Anspruch 5,
**dadurch gekennzeichnet ,**
**dass** sich die wenigstens eine Zuführeinrichtung (9) in dem Becken (3) zumindest abschnittsweise, vorzugsweise vollständig, nicht parallel zur Transportrichtung (6) erstreckt.

7. Behandlungsvorrichtung (1) nach Anspruch 5 oder 6,
**dadurch gekennzeichnet,**
**dass** die wenigstens eine Zuführeinrichtung (9) zumindest abschnittsweise eine gerade Erstreckung (10) aufweist, welche schräg zur Transportrichtung (6) ausgerichtet ist.

8. Behandlungsvorrichtung (1) nach Anspruch 7,
**dadurch gekennzeichnet,**
**dass** sich besagte gerade Erstreckung (10) über die gesamte Länge (L) der wenigstens einen Zuführeinrichtung (9) erstreckt und mittels der nach oben gerichteten Austrittsöffnungen (13) der wenigstens einen Zuführeinrichtung (9) sich kegelförmig aufweitende Behandlungslösungsstrahlen (24) ausbildbar sind, wobei die gerade Erstreckung (10) in einem Winkel α zu der Transportrichtung (6) ausgerichtet ist, für den zumindest näherungsweise gilt α = arcsin((B - 2R)/L), wobei L die Länge der wenigstens einen Zuführeinrichtung (9) ist, B die Breite der zu behandelnden Objekte (2) ist und R der Radius der Behandlungslösungsstrahlen (24) auf Höhe einer Transportebene (22) der Transportvorrichtung (5) ist.

9. Behandlungsvorrichtung (1) nach einem der Ansprüche 5 bis 8,
**dadurch gekennzeichnet,**
**dass** die wenigstens eine Zuführeinrichtung (9) mehrere nach oben gerichtete Austrittsöffnungen (13) aufweist, welche in einer Längserstreckungsrichtung (25) der wenigstens einen Zuführeinrichtung (9) beabstandet voneinander angeordnet sind.

10. Behandlungsvorrichtung (1) nach einem der Ansprüche 5 bis 9,
**dadurch gekennzeichnet,**
**dass** die wenigstens eine Zuführeinrichtung mehrere schräg oder senkrecht zur Transportrichtung (6) nebeneinander angeordnete nach oben gerichtete Austrittsöffnungen (13) zum nach oben Abstrahlen der Behandlungslösung (4) aufweist.

11. Behandlungsvorrichtung (1) nach einem der Ansprüche 5 bis 10,
**dadurch gekennzeichnet,**
**dass** die Transportvorrichtung (5) mehrere in Transportrichtung (6) hintereinander angeordnete Transportrollen (8) aufweist und die wenigstens eine Zuführeinrichtung (9) unterhalb der Transportrollen (8) angeordnet ist, wobei die nach oben gerichteten Austrittsöffnungen (13) der wenigstens einen Zuführeinrichtung (9), bezogen auf die Transportrichtung (6), an den Positionen der Transportrollen (8) angeordnet sind.

12. Behandlungsvorrichtung (1) nach einem der Ansprüche 5 bis 11,
**g e k e n n z e ich n e t durch**
eine Entgasungsvorrichtung (18) zum Entfernen von Gasblasen und/oder gasblasenreicher Behandlungslösung (4) aus der wenigstens einen Zuführeinrichtung (9), wobei die Entgasungsvorrichtung (18) eine Abführleitung (19) aufweist, welche mit der wenigstens einen Zuführeinrichtung (9) verbunden ist.

13. Behandlungsvorrichtung (1) nach einem der Ansprüche 5 bis 12,
**dadurch gekennzeichnet,**
**dass** die Behandlungsvorrichtung (1) dazu eingerichtet ist, die zu behandelnden Objekte (2) in mehreren Spuren (7) nebeneinander entlang der Transportrichtung (6) zu transportieren, und die wenigstens eine Zuführeinrichtung (9) eine von mehreren, insbesondere baugleichen Zuführeinrichtungen (9) ist, wobei die Behandlungsvorrichtung (1) für jede Spur (7) jeweils eine eigene Zuführeinrichtung (9) aufweist.

## Claims

1. A method for treating objects (2), in the case of which method:
- objects (2) to be treated are transported through a basin (3) by means of a transport apparatus (5);
- treatment solution (4) is introduced into the basin (3) by means of at least one feed device (9) which is provided with upwardly directed outlet openings (13), and the treatment solution (4) is sprayed out upward here by means of the upwardly directed outlet openings (13) with the configuration of treatment solution jets (24);
- the objects (2) being transported through the basin (3) above the upwardly directed outlet openings (13);
- during the transport of the objects (2) through the basin (3), a downwardly pointing surface (23) of the objects (2) being brought into contact with the treatment solution jets (24) ;
- the at least one feed device (9) is configured as a tube-in-tube system with an outer tube (11) and an inner tube (12) which is arranged in the outer tube (11), the treatment solution (4) being introduced into the outer tube (11) via downwardly directed outlet openings (14) of the inner tube (12), and the treatment solution jets (24) being sprayed out of the outer tube (11) upward into the basin (3) .

2. The method as claimed in claim 1,
**characterized**
**in that** the treatment is a single-sided treatment, in the case of which the downwardly pointing surface (23) of the objects (2) is treated with the treatment solution (4).

3. The method as claimed in claim 1 or 2,
**characterized**
**in that**, during the transport of the objects (2) through the basin (3), each point of the downwardly pointing surface (23) of the objects (2) is brought into contact with the treatment solution jets (24) in such a way that, after running through the basin (3), each point of the downwardly pointing surface (23) of the objects (2) has been treated with the treatment solution jets (24) for an equally long time.

4. The method as claimed in one of the preceding claims,
**characterized**
**in that** the treatment solution jets (24) are configured in treatment solution (4) which is already contained in the basin (3).

5. A treatment apparatus (1) for carrying out a method as claimed in one of the preceding claims, comprising
- a basin (3), in which a treatment solution (4) can be arranged;
- a transport apparatus (5), by means of which objects (2) to be treated can be transported in a transport direction (6) through the basin (3);
- at least one feed device (9) which is arranged in the basin (3) and by means of which treatment solution (4) can be introduced into the basin (3);
- the at least one feed device (9) having upwardly directed outlet openings (13) for spraying out the treatment solution (4) upward, wherein the at least one feed device (9) is configured as a tube-in-tube system with an outer tube (11) and an inner tube (12) which is arranged in the outer tube (11), the outer tube (11) having the upwardly directed outlet openings (13) for spraying out the treatment solution (4) upward, and the inner tube (12) having downwardly directed outlet openings (14), via which the treatment solution (4) can be introduced into the outer tube (12).

6. The treatment apparatus (1) as claimed in claim 5,
**characterized**
**in that** the at least one feed device (9) extends in the basin (3) at least in sections, preferably completely, in a non-parallel manner with respect to the transport direction (6) .

7. The treatment apparatus (1) as claimed in claim 5 or 6,
**characterized**
**in that**, at least in sections, the at least one feed device (9) has a straight extent (10) which is oriented obliquely with respect to the transport direction (6).

8. The treatment apparatus (1) as claimed in claim 7,
**characterized**
**in that** said straight extent (10) extends over the entire length (L) of the at least one feed device (9), and treatment solution jets (24) which widen conically can be configured by means of the upwardly directed outlet openings (13) of the at least one feed device (9), the straight extent (10) being oriented at an angle α with respect to the transport direction (6), for which angle α it is the case at least approximately that α = arcsin((B - 2R)/L), L being the length of the at least one feed device (9), B being the width of the objects (2) to be treated, and R being the radius of the treatment solution jets (24) at the level of a transport plane (22) of the transport apparatus (5).

9. The treatment apparatus (1) as claimed in one of claims 5 to 8,
**characterized**
**in that** the at least one feed device (9) has a plurality of upwardly directed outlet openings (13) which are arranged spaced apart from one another in a longitudinal extent direction (25) of the at least one feed device (9).

10. The treatment apparatus (1) as claimed in one of claims 5 to 9,
**characterized**
**in that** the at least one feed device has a plurality of upwardly directed outlet openings (13) which are arranged next to one another obliquely or perpendicularly with respect to the transport direction (6) for spraying out the treatment solution (4) upward.

11. The treatment apparatus (1) as claimed in one of claims 5 to 10,
**characterized**
**in that** the transport apparatus (5) has a plurality of transport rollers (8) which are arranged behind one another in the transport direction (6), and the at least one feed device (9) is arranged below the transport rollers (8), the upwardly directed outlet openings (13) of the at least one feed device (9) being arranged at the positions of the transport rollers (8), in relation to the transport direction (6).

12. The treatment apparatus (1) as claimed in one of claims 5 to 11,
**characterized by**
a degassing apparatus (18) for the removal of gas bubbles and/or gas bubbles-rich treatment solution (4) from the at least one feed device (9), the degassing apparatus (18) having a discharge line (19) which is connected to the at least one feed device (9).

13. The treatment apparatus (1) as claimed in one of claims 5 to 12,
**characterized**
**in that** the treatment apparatus (1) is set up to transport the objects (2) to be treated in a plurality of tracks (7) next to one another along the transport direction (6), and the at least one feed device (9) is one of a plurality of (in particular, structurally identical) feed devices (9), the treatment apparatus (1) in each case having a dedicated feed device (9) for each track (7).

## Revendications

1. Procédé pour le traitement d'objets (2), dans lequel
- les objets à traiter (2) sont transportés à travers un bassin (3) au moyen d'un dispositif de transport (5) ;
- une solution de traitement (4) est introduite dans le bassin (3) au moyen d'au moins un dispositif d'alimentation (9) pourvu d'ouvertures de sortie (13) dirigées vers le haut et la solution de traitement (4) est alors projetée de façon rayonnée vers le haut au moyen des ouvertures de sortie (13) dirigées vers le haut en formant des jets de solution de traitement (24) ;
- les objets (2) étant transportés à travers le bassin (3) au-dessus des ouvertures de sortie (13) dirigées vers le haut ;
- pendant le transport des objets (2) à travers le bassin (3), une surface (23) des objets (2) orientée vers le bas est mise en contact avec les jets de solution de traitement (24) ;
- ledit au moins un dispositif d'alimentation (9) est conçu sous la forme d'un système tube-dans-tube ayant un tube extérieur (11) et un tube intérieur (12) agencé dans le tube extérieur (11), la solution de traitement (4) étant introduite dans le tube extérieur (11) par des ouvertures de sortie (14) du tube intérieur (12) dirigées vers le bas et les jets de solution de traitement (24) étant projetés de façon rayonnée vers le haut dans le bassin (3) à partir du tube extérieur (11).

2. Procédé selon la revendication 1,
**caractérisé en ce que**
le traitement est un traitement unilatéral, dans lequel la surface (23) des objets (2) orientée vers le bas est traitée avec la solution de traitement (4).

3. Procédé selon la revendication 1 ou la revendication 2,
**caractérisé**
**en ce que**, pendant le transport des objets (2) à travers le bassin (3), chaque point de la surface (23) des objets (2) orientée vers le bas est mis en contact avec les jets de solution de traitement (24) de telle sorte qu'après avoir traversé le bassin (3), chaque point de la surface (23) des objets (2) orientée vers le bas a été traité pendant une durée égale par les jets de solution de traitement (24).

4. Procédé selon l'une des revendications précédentes,
**caractérisé**
**en ce que** les jets de solution de traitement (24) sont formés dans la solution de traitement (4) déjà contenue dans le bassin (3).

5. Dispositif de traitement (1) pour la mise en œuvre d'un procédé selon l'une des revendications précédentes, comprenant
- un bassin (3) dans lequel une solution de traitement (4) est apte à être disposée ;
- un dispositif de transport (5), au moyen duquel des objets à traiter (2) sont aptes à être transportés dans une direction de transport (6) à travers le bassin (3) ;
- au moins un dispositif d'alimentation (9) agencé dans le bassin (3), au moyen duquel une solution de traitement (4) est apte à être introduite dans le bassin (3) ;
- ledit au moins un dispositif d'alimentation (9) présentant des ouvertures de sortie (13) orientées vers le haut pour la projection rayonnée vers le haut de la solution de traitement (4), ledit au moins un dispositif d'alimentation (9) étant conçu sous la forme d'un système tube-dans-tube ayant un tube extérieur (11) et un tube intérieur (12) agencé dans le tube extérieur (11), le tube extérieur (11) présentant les ouvertures de sortie (13) orientées vers le haut pour la projection rayonnée vers le haut de la solution de traitement (4) et le tube intérieur (12) présentant des ouvertures de sortie (14) orientées vers le bas, par lesquelles la solution de traitement (4) est apte à être introduite dans le tube extérieur (12).

6. Dispositif de traitement (1) selon la revendication 5,
**caractérisé**
**en ce que** ledit au moins un dispositif d'alimentation (9) s'étend dans le bassin (3) au moins partiellement, de préférence entièrement, non parallèlement à la direction de transport (6).

7. Dispositif de traitement (1) selon la revendication 5 ou 6,
**caractérisé**
**en ce que** ledit au moins un dispositif d'alimentation (9) présente au moins partiellement une extension droite (10) qui est orientée obliquement par rapport à la direction de transport (6).

8. Dispositif de traitement (1) selon la revendication 7,
**caractérisé**
**en ce que** ladite extension droite (10) s'étend sur toute la longueur (L) dudit au moins un dispositif d'alimentation (9) et en ce que des jets de solution de traitement (24) s'élargissant en forme de cône sont aptes à être formés au moyen des ouvertures de sortie (13) orientées vers le haut dudit au moins un dispositif d'alimentation (9), l'extension droite (10) étant orientée selon un angle α par rapport à la direction de transport (6), pour lequel est vérifiée au moins approximativement α = arcsin((B - 2R)/L), L étant la longueur dudit au moins un dispositif d'alimentation (9), B étant la largeur des objets (2) à traiter et R étant le rayon des rayons de solution de traitement (24) à hauteur d'un plan de transport (22) du dispositif de transport (5).

9. Dispositif de traitement (1) selon l'une des revendications 5 à 8,
**caractérisé**
**en ce que** ledit au moins un dispositif d'alimentation (9) présente une pluralité d'ouvertures de sortie (13) dirigées vers le haut, qui sont aménagées à distance les unes des autres dans une direction d'extension longitudinale (25) dudit au moins un dispositif d'alimentation (9).

10. Dispositif de traitement (1) selon l'une des revendications 5 à 9,
**caractérisé**
**en ce que** ledit au moins un dispositif d'alimentation présente plusieurs ouvertures de sortie (13) orientées vers le haut, aménagées les unes à côté des autres de façon oblique ou perpendiculairement à la direction de transport (6), pour le rayonnement vers le haut de la solution de traitement (4).

11. Dispositif de traitement (1) selon l'une des revendications 5 à 10,
**caractérisé**
**en ce que** le dispositif de transport (5) comporte plusieurs rouleaux de transport (8) agencés les uns derrière les autres dans la direction de transport (6) et ledit au moins un dispositif d'alimentation (9) est agencé en dessous des rouleaux de transport (8), les ouvertures de sortie (13) orientées vers le haut dudit au moins un dispositif d'alimentation (9) étant agencées, par rapport à la direction de transport (6), aux positions des rouleaux de transport (8).

12. Dispositif de traitement (1) selon l'une des revendications 5 à 11,
**caractérisé par**
un dispositif de dégazage (18) pour éliminer les bulles de gaz et/ou la solution de traitement (4) riche en bulles de gaz dudit au moins un dispositif d'alimentation (9), ledit dispositif de dégazage (18) comprenant une conduite d'évacuation (19) qui est reliée audit au moins un dispositif d'alimentation (9).

13. Dispositif de traitement (1) selon l'une des revendications 5 à 12,
**caractérisé**
**en ce que** le dispositif de traitement (1) est conçu de façon à transporter les objets à traiter (2) sur plusieurs voies (7), les unes à côté des autres, le long de la direction de transport (6), et ledit au moins un dispositif d'alimentation (9) est l'un parmi plusieurs dispositifs d'alimentation (9), en particulier de construction identique, le dispositif de traitement (1) présentant, pour chaque voie (7) respectivement, un dispositif d'alimentation (9) propre.
